# EUROPEAN PATENT APPLICATION

(11) **EP 4 818 359 A1**
(43) Date of publication of application: **07.10.2026**
(21) Application number: 24891101.8
(22) Date of filing: 27.09.2024
(51) Int. Cl.: C23C 16/36, C23C 16/38, C23C 16/455, H01L 21/314, H01L 21/318

(54) **METHOD FOR FORMING BORON CARBONITRIDE-CONTAINING FILM**

(30) Priority: 13.11.2023 JP 2023192798
(71) Applicant: L'Air Liquide, Société Anonyme pour l'Etude et l'Exploitation des Procédés Georges Claude, 75007 Paris (FR)
(72) Inventor: NESTEROV, Vitaly, Yokosuka-shi, Kanagawa 239-0847 (JP); GIRARD, Jean-Marc, 75007 Paris (FR)
(74) Representative: Air Liquide
(86) International application number: PCT/JP2024/034761
(87) International publication number: WO 2025/105059

(57) **Abstract**

To provide a method for effectively forming a boron carbonitride-containing film on a substrate; a substrate on which a boron carbonitride-containing film has been formed by said method; and a product comprising the substrate.

[Solution]

A carbon-nitrogen source compound represented by formula (1):

R¹₃E-N=C=N-ER¹₃

[in formula (1), E are independently Si, Ge, or Sn, and R¹ are independently a linear or cyclic C1-C6 alkyl, C2-C6 alkenyl, or C1-C6 alkynyl]
is used, for example.

## Description

### [Technical Field]

The present disclosure relates to a method for forming a boron carbonitride-containing film on a substrate. Furthermore, the present disclosure also relates to a substrate on which a boron carbonitride-containing film has been formed, and to a product comprising this substrate.

### [Background Art]

Attention is focusing on technology for forming boron carbonitride-containing films on substrates used in various industrial products including electronic devices, in order to protect the substrates.

Non-Patent Document 1 indicates that boron carbonitride-containing films have outstanding physical and chemical properties and are useful for protecting substrates used in various industrial products including electronic devices.

### [Prior Art Documents]

### [Non-Patent Documents]

[Non-Patent Document1] S.D. Nahate et al., Mater. Today Adv. 8, 100106 (2020)

### [Summary of the Invention]

The present disclosure provides a method for forming a boron carbonitride-containing film that allows a boron carbonitride-containing film having outstanding properties to be efficiently formed on a substrate. The present disclosure furthermore provides a substrate on which a boron carbonitride-containing film having outstanding properties has been formed, and a product comprising such a substrate.

The method for forming a boron carbonitride-containing film according to the present disclosure is as follows, for example.

A method for forming a boron carbonitride-containing film on a substrate, the method comprising:
(i) supplying at least one boron source compound containing at least one boron halide onto the substrate; and
(ii) supplying, onto the substrate, a carbon-nitrogen source compound represented by formula (1):

   R¹₃E-N=C=N-ER¹₃

   [in formula (1), E are independently Si, Ge or Sn, and R¹ are independently a C1-C6 alkyl, C2-C6 alkenyl, C4-C6 cycloalkyl, or C4-C6 cycloalkenyl].

### [Brief Description of the Drawings]

[Fig. 1] Fig. 1 shows an example of a reaction cycle in an ALD process in the present disclosure.
[Fig. 2] Fig. 2 shows an example of a scheme for implementing the ALD process in the present disclosure.
[Fig. 3] Fig. 3 shows an example of a scheme for implementing the ALD process involving treatment with hydrogen, helium or argon plasma, or a mixed plasma thereof in the present disclosure.
[Fig. 4] Fig. 4 is a capacitance-voltage (C-V) curve for a metal-insulator-semiconductor (MIS) element (metal: Pt, insulator: BCN, semiconductor: Si).
[Fig. 5] Fig. 5 shows analysis results for constituent components of a boron carbonitride-containing film according to example 1, obtained by X-ray photoelectron spectroscopy (XPS).
[Fig. 6] Fig. 6 shows analysis results for constituent components of a boron carbonitride-containing film according to example 2, obtained by X-ray photoelectron spectroscopy (XPS).

### [Embodiments of the Invention]

Embodiments of the present disclosure are described in detail below, but the scope of the present invention is not limited to the embodiments described here, and various changes can be made without departing from the spirit of the present invention. Embodiments may be implemented individually or in combinations of more than one. Particular descriptions of one embodiment that are applicable to other embodiments will not be repeated for such other embodiments.

The numerical ranges in the present disclosure include the upper and lower limits, respectively, that are indicated with "-" and "from". For example, the statement "A-B" or "A to B" using numerical values A and B means A or more to B or less. The expressions "A-B", "A to B", or "A or more to B or less" that are used to indicate the stepwise numerical ranges in the present disclosure also independently include both "preferably A or more" and "preferably B or less", where the lower and upper limits may be replaced with other numerical range upper and lower limits. The lower or upper limits of the numerical ranges given in the present disclosure are numerical values within the numerical range, and may be replaced with the numerical values given in the examples.

The singular forms "a", "an", and "the" used in the present disclosure may include more than one referent, unless otherwise clearly specified. As used in the present disclosure, "and/or" includes both relationships expressed by "and" and relationships expressed by "or". In the present disclosure, "comprises" encompasses "consists primarily of", "consists substantially of", and "consists of", while "consists primarily of" encompasses "consists substantially of" and "consists of", and "consists substantially of" encompasses "consists of".

### [Method for forming boron carbonitride-containing film]

One embodiment provides:
a method for forming a boron carbonitride-containing film on a substrate, the method comprising:
(i) supplying at least one boron source compound containing at least one boron halide onto the substrate; and
(ii):
   supplying, onto the substrate, a carbon-nitrogen source compound represented by:

   R¹₃E-N=C=N-ER¹₃

   [in formula (1), E are independently Si, Ge or Sn, and R¹ are independently a C1-C6 alkyl, C2-C6 alkenyl, C4-C6 cycloalkyl, or C4-C6 cycloalkenyl].

In this embodiment, at least one boron source compound containing at least one boron halide reacts with a carbon-nitrogen source compound represented by formula (1), resulting in the formation of a boron carbonitride-containing film. Reaction by-products (e.g., the reaction by-product when BCl₃ is used as the boron source compound and when a compound in which R¹ in formula (1) is CH₃ and E is Si is used as the carbon-nitrogen source compound is chlorotrimethylsilane) are generally not salts and are highly volatile. The reaction by-products can thus easily be removed from the reaction system.

In order to produce boron carbonitride-containing films in conventional methods, on the other hand, ethylene, methane, and acetylene, for example, are typically used as carbon source compounds, while ammonia, hydrazine, amine, and alkylhydrazine for example, are used as nitrogen source compounds. In these cases, salts (e.g., ammonium halide) occur as by-products of the reaction between the boron source compound and the nitrogen source compound. The salts generally have low volatility and are not easy to remove from the reaction system.

Specifically, the method of this embodiment allows the amount of by-products contaminating the boron carbonitride-containing film to be reduced. Potential salt contamination of the boron carbonitride-containing film can therefore be reduced or eliminated. The method of this embodiment thus also allows a more homogeneous boron carbonitride-containing film of higher purity to be formed on the substrate, affording stronger substrate protection. Potential structural and functional substrate damage as a result of by-product adhesion on the substrate can also be mitigated.

In this embodiment, a single compound can be used as the carbon-nitrogen source compound, thus eliminating the need to separately prepare and use a carbon source compound and a nitrogen source compound, unlike in conventional methods. The method of this embodiment thus allows a boron carbonitride-containing film to be formed on a substrate more easily and efficiently than in conventional methods.

This embodiment can also reduce or eliminate the potential formation of C-H, N-H, and E-H bonds in the boron carbonitride-containing film, which can adversely affect the sensitivity of the boron carbonitride-containing film to humidity, wet etching, and ashing.

In this embodiment, the boron carbonitride-containing film is any film that contains boron carbonitride. The boron carbonitride-containing film may be a boron carbonitride film or a silicoboron carbonitride film. Furthermore, the boron carbonitride-containing film may be a mixture of a boron carbonitride film and a silicoboron carbonitride film.

In this embodiment, E in formula (1) is preferably Si, and R¹ is preferably a C1-C6 alkyl, and more preferably CH₃. Non-limiting examples of the compound of formula (1) which may be cited include: (H₃C)₃Si-N=C=N-Si(CH₃)₃, (H₅C₂)₃Si-N=C=N-Si(C₂H₅)₃, (H₃C₂)₃Si-N=C=N-Si(C₂H₃)₃, (H₇C₃)₃Si-N=C=N-Si(C₃H₇)₃, (H₅C₃)₃Si-N=C=N-Si(C₃H₅)₃, (H₃C₃)₃Si-N=C=N-Si(C₃H₃)₃, (H₉C₄)₃Si-N=C=N-Si(C₄H₉)₃, (H₇C₄)₃Si-N=C=N-Si(C₄H₇)₃, (H₅C₄)₃Si-N=C=N-Si(C₄H₅)₃, (H₁₁C₅)₃Si-N=C=N-Si(C₅H₁₁)₃, (H₉C₅)₃Si-N=C=N-Si(C₅H₉)₃, (H₇C₅)₃Si-N=C=N-Si(C₅H₇)₃, (H₁₃C₆)₃Si-N=C=N-Si(C₆H₁₃)₃, (H₁₁C₆)₃Si-N=C=N-Si(C₆H₁₁)₃, (H₉C₆)₃Si-N=C=N-Si(C₆H₉)₃, (H₅C₆)₃Si-N=C=N-Si(C₆H₅)₃, (H₃C)₃Ge-N=C=N-Ge(CH₃)₃, (H₅C₂)₃Ge-N=C=N-Ge(C₂H₅)₃, (H₃C₂)₃Ge-N=C=N-Ge(C₂H₃)₃, (H₇C₃)₃Ge-N=C=N-Ge(C₃H₇)₃, (H₅C₃)₃Ge-N=C=N-Ge(C₃H₅)₃, (H₃C₃)₃Ge-N=C=N-Ge(C₃H₃)₃, (H₉C₄)₃Ge-N=C=N-Ge(C₄H₉)₃, (H₇C₄)₃Ge-N=C=N-Ge(C₄H₇)₃, (H₅C₄)₃Ge-N=C=N-Ge(C₄H₅)₃, (H₁₁C₅)₃Ge-N=C=N-Ge(C₅H₁₁)₃, (H₉C₅)₃Ge-N=C=N-Ge(C₅H₉)₃, (H₇C₅)₃Ge-N=C=N-Ge(C₅H₇)₃, (H₁₃C₆)₃Ge-N=C=N-Ge(C₆H₁₃)₃, (H₁₁C₆)₃GeN=C=N-Ge(C₆H₁₁)₃, (H₉C₆)₃Ge-N=C=N-Ge(C₆H₉)₃, (H₅C₆)₃Ge-N=C=N-Ge(C₆H₅)₃, (H₃C)₃Sn-N=C=N-Sn(CH₃)₃, (H₅C₂)₃Sn-N=C=N-Sn(C₂H₅)₃, (H₃C₂)₃Sn-N=C=N-Sn(C₂H₃)₃, (H₇C₃)₃Sn-N=C=N-Sn(C₃H₇)₃, (H₅C₃)₃Sn-N=C=N-Sn(C₃H₅)₃, (H₃C₃)₃Sn-N=C=N-Sn(C₃H₃)₃, (H₉C₄)₃Sn-N=C=N-Sn(C₄H₉)₃, (H₇C₄)₃Sn-N=C=N-Sn(C₄H₇)₃, (H₅C₄)₃Sn-N=C=N-Sn(C₄H₅)₃, (H₁₁C₅)₃Sn-N=C=N-Sn(C₅H₁₁)₃, (H₉C₅)₃Sn-N=C=N-Sn(C₅H₉)₃, (H₇C₅)₃Sn-N=C=N-Sn(C₅H₇)₃, (H₁₃C₆)₃Sn-N=C=N-Sn(C₆H₁₃)₃, (H₁₁C₆)₃Sn-N=C=N-Sn(C₆H11)₃, (H₉C₆)₃Sn-N=C=N-Sn(C₆H₉)₃, and (H₅C₆)₃Sn-N=C=N-Sn(C₆H₅)₃. The compounds of formula (1) may be used alone or in combinations of two or more.

In this embodiment, the at least one boron source compound may be at least one compound selected from the group consisting of: BCl₃, BBr₃, BI₃, CH₃BCl₂, CH₃Br₂, C₆H₅BCl₂, borazine, 2,4,6-trichloroborazine, 1,3,5-trimethyl-2,4,6-trichloroborazine, and 1,3,5-triethyl-2,4,6-trichloroborazine.

Furthermore, the at least one boron source compound may be a compound represented by formula (2):

X₃Si-[CR²R³]ₙ-BX₂

[in formula (2), X is Cl, Br, or I; R² and R³ are independently H or a C1-C6 alkyl, C2-C6 alkenyl, C4-C6 cycloalkyl, or C4-C6 cycloalkenyl; R² and R³ may be bonded to each other by C-C bonds to form a carbon ring structure; and n is an integer of 1-10].
In formula (2), X is preferably Cl or Br. R² and R³ are independently preferably H or a C1-C6 alkyl, and more preferably H or CH₃. n is preferably 1-3, and more preferably 1.

The compound represented by formula (2) may be a compound selected from the group consisting of: Cl₃Si-CH₂-BCl₂, Cl₃Si-CH(CH₃)-BCl₂, Cl₃Si-C(CH₃)₂-BCl₂, Cl₃Si-C(CH₂)-BCl₂, Cl₃Si-C[C(CH₃)₂]-BCl₂, Br₃Si-CH₂-BCl₂, Br₃Si-CH₂-BBr₂, Br₃Si-CH(CH₃)-BCl₂, Br₃Si-CH(CH₃)-BBr₂, Br₃Si-C(CH₃)₂-BCl₂, Br₃Si-C(CH₃)₂-BBr₂, Br₃Si-C(CH₂)-BCl₂, Br₃Si-C(CH₂)-BBr₂, Br₃Si-C[C(CH₃)₂]-BCl₂, Br₃Si-C[C(CH₃)₂]-BBr₂, Cl₃Si-CH₂-BBr₂, Cl₃Si-CH(CH₃)-BBr₂, Cl₃SiC(CH₃)₂-BBr₂, Cl₃Si-C(CH₂)-BBr₂, and Cl₃Si-C[C(CH₃)₂]-BBr₂.

Furthermore, the at least one boron source compound may be a compound represented by formula (3):

X₂B-Aₙ-BX₂

[in formula (3):
(i) A is CR²R³, n is an integer of 1-6, or (ii) A is C=CR²R³, and n is 1;
R² and R³ are independently H, or a C1-C6 alkyl, C2-C6 alkenyl, C4-C6 cycloalkyl, or C4-C6 cycloalkenyl;
R² and R³ may be bonded to each other by C-C bonds to form a carbon ring structure; and
X is F, Cl, Br or I].
In formula (3), X is preferably Cl, Br or I, and more preferably Cl or Br. R² and R³ are independently preferably H or a C1-C6 alkyl, and more preferably H or CH₃. In formula (3), when A is CR²R³, n is preferably 1 or 2, and more preferably 1.

The compound represented by formula (3) may be a compound selected from the group consisting of: Cl₂B-CH₂-BCl₂, Cl₂B-CH(CH₃)-BCl₂, Cl₂B-C(CH₃)₂-BCl₂, Cl₂B-C(CH₂)-BCl₂, Cl₂B-C[C(CH₃)₂]-BCl₂, Br₂B-CH₂-BBr₂, Br₂B-CH(CH₃)-BBr₂, Br₂B-C(CH₃)₂-BBr₂, Br₂B-C(CH₂)-BBr₂, Br₂B-C[C(CH₃)₂]-BBr₂, Cl₂B-CH₂-BBr₂, Cl₂B-CH(CH₃)-BBr₂, Cl₂B-C(CH₃)₂-BBr₂, Cl₂B-C(CH₂)-BBr₂, and Cl₂B-C[C(CH₃)₂]-BBr₂.

In this embodiment, the method for forming a boron carbonitride-containing film on a substrate may further comprise:
(iii) supplying a nitrogen-containing reagent onto the substrate.

Here, the compound used as the abovementioned carbon-nitrogen source compound is excluded from nitrogen-containing reagents.

The use of the abovementioned carbon-nitrogen source compounds will allow the amount of by-products contaminating the boron carbonitride-containing film to be reduced in this case as well. Potential salt contamination of the boron carbonitride-containing film can furthermore be reduced.

Further supplying a nitrogen-containing reagent onto the substrate in the method of this embodiment can result in more advantageous features such as a better film formation rate and a lower temperature during film formation. The nitrogen content in the boron carbonitride-containing film can be increased, thereby improving the physical and chemical properties (such as the dielectric constant and etching resistance) of the boron carbonitride-containing film. Halogen residues in the boron carbonitride-containing film can also be reduced.

There is no particular limitation as to the timing at which the nitrogen-containing reagent is supplied onto the substrate, to the extent that it does not impair the effect of the present invention, but the nitrogen-containing reagent is typically supplied onto the substrate after the carbon-nitrogen source compound has been supplied. Supplying the nitrogen-containing reagent onto the substrate after the carbon-nitrogen source compound has been supplied can allow the carbon-nitrogen source compound to react sufficiently before the highly-reactive nitrogen-containing reagent is supplied onto the substrate.

The nitrogen-containing reagent may be:
(i) one or more selected from the group consisting of ammonia, amines, hydrazines, alkylhydrazines, hexamethyldisilazane, and heptamethyldisilazane;
(ii) one or more plasmas selected from the group consisting of ammonia, amines, hydrazines, alkylhydrazines, hexamethyldisilazanes, and heptamethyldisilazanes;
(iii) nitrogen plasma; or
(iv) a mixture of hydrogen plasma with (ii) one or more plasmas selected from the group consisting of ammonia, amines, hydrazines, alkylhydrazines, hexamethyldisilazanes, and heptamethyldisilazanes, or (iii) nitrogen plasma.

The mixture (iv) here may be, for example, a plasma obtained from a mixture of nitrogen gas and hydrogen gas.

The plasma may be, for example, a direct plasma or a remote plasma. The use of a nitrogen-containing gas that contains a highly-reactive plasma and that has suitably adjusted properties will be advantageous in suitably adjusting the nitrogen content in the boron carbonitride-containing film. The use of a nitrogen-containing reagent that contains a plasma can also reduce or curb the formation of C=N and C≡N bonds in the film, which strongly affect the electrical properties and reactivity of boron carbonitride-containing films. The use of a nitrogen-containing reagent that contains a plasma will thus allow the dielectric constant of the boron carbonitride-containing film to be effectively lowered (to a k of no more than 2, for example) and the etching resistance to be effectively enhanced.

In this embodiment, the at least one boron source compound and carbon-nitrogen source compound may be supplied sequentially onto the substrate. The at least one boron source compound and carbon-nitrogen source compound may also be supplied simultaneously onto the substrate.

In this embodiment, the boron carbonitride-containing film may be formed on the substrate by a chemical vapour deposition (CVD) process. CVD is a process in which a gas containing a boron carbonitride-containing film raw material is supplied onto the surface of a substrate in a reactor to form a thin film on the substrate via a chemical reaction on the substrate surface or in the gas phase. CVD processes that use heat, plasma, or light to induce a chemical reaction are referred to as thermal CVD, plasma-enhanced CVD (PECVD), and photo-initiated CVD, respectively. Atomic layer deposition (ALD) is a CVD process in which a thin film is formed on a substrate via repeated cycles in which a gas containing two or more raw materials is successively introduced and exhausted, and the raw material molecules adsorbed onto the film-forming surface are reacted, resulting in sequential deposition of atomic layers, one layer at a time.

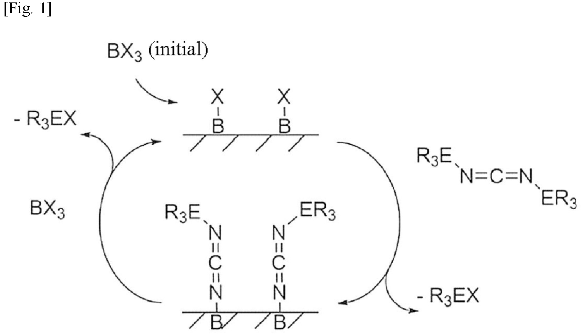

In this embodiment, any CVD process may be used, but ALD is preferably used. Fig. 1 shows an exemplary chemical reaction in the ALD process.

Fig. 1 shows an example of the chemical reaction when BX₃ [X is Cl, Br or I] was used as the boron source compound, and R₃E-N=C=N-ER₃ [E is Si, Ge or Sn, and R is CH₃] was used as the carbon-nitrogen source compound. That is to say, BX₃ is introduced into the reaction system and a thin layer comprising BX on the surface is deposited onto the substrate. R₃E-N=C=N-ER₃ is introduced into the reaction system next and chemically reacts with the BX on the thin layer, whereby R₃EX is formed as a by-product and -N=C=N-ER₃ is bonded to B on the thin layer. BX₃ is further introduced into the reaction system and chemically reacts with -N=C=N-ER₃ on the thin layer, whereby R₃EX is formed as a by-product and a new thin layer is formed. This series of chemical reactions constitutes one cycle, where the cycle is repeated until the boron carbonitride-containing film reaches the intended thickness, resulting in the formation of a thin layer on the substrate.

In this embodiment, (i) the at least one boron source compound containing at least one boron halide, (ii) the carbon-nitrogen source compound represented by formula (1), and/or (iii) the nitrogen-containing reagent may be supplied onto the substrate by respectively supplying onto the substrate: (i) a gas comprising at least one boron source compound containing at least one boron halide, (ii) a gas comprising the carbon-nitrogen source compound represented by formula (1), and/or (iii) a gas comprising the nitrogen-containing reagent.

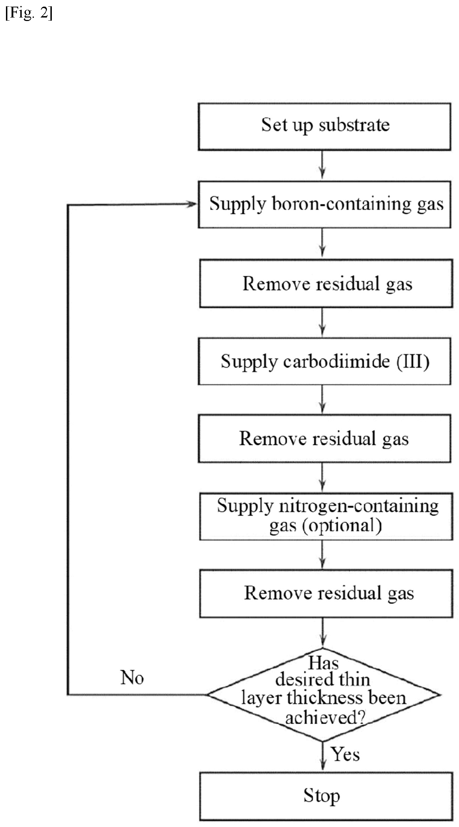

Fig. 2 shows an exemplary scheme for implementing the ALD process in this embodiment. In fig. 2, the "boron-containing gas" is the gas comprising at least one boron source compound, the "carbodiimide (III)" is the carbon-nitrogen source compound represented by formula (1), and the "nitrogen-containing gas" is the gas comprising the nitrogen-containing reagent.

In the scheme shown in fig. 2, the boron-containing gas is supplied onto a substrate that has been set up in a device, and the residual gas is then removed. The gas that contains the carbodiimide (III) is then supplied, and the residual gas is then removed. The nitrogen-containing gas is then supplied, as needed, and the residual gas is then removed. These operations constitute one cycle, where the cycle is repeated until the boron carbonitride-containing film reaches the intended thickness, resulting in the formation of a thin layer on the substrate.

The timing at which the nitrogen-containing gas is supplied in fig. 2 is an example, and the nitrogen-containing gas can actually be supplied at any timing. For example, the nitrogen-containing gas can be supplied in small amounts at the same time as the gas that contains the carbodiimide (III). In such cases, the amount of carbodiimide (III) that is going to be reacted can also be adjusted by setting the conditions to a lean carbodiimide (III) feed.

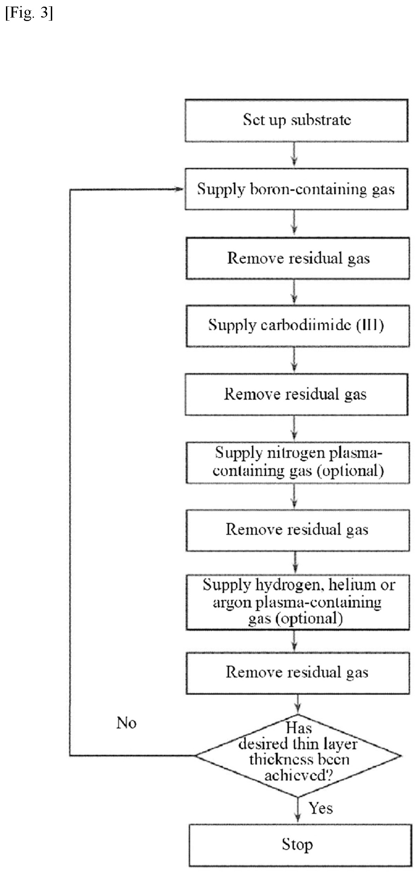

The ALD process in this embodiment may involve treatment with a hydrogen, helium, or argon plasma, or a plasma mixture thereof. Fig. 3 shows an exemplary scheme for implementing the ALD process in this case. In fig. 3, the "boron-containing gas" is the gas comprising at least one boron source compound, the "carbodiimide (III)" is the carbon-nitrogen source compound represented by formula (1), and the "nitrogen plasma-containing gas" is the gas comprising the nitrogen-containing reagent.

In the scheme shown in fig. 3, the boron-containing gas is supplied onto a substrate that has been set up in a device, and the residual gas is then removed. The gas that contains the carbodiimide (III) is then supplied, and the residual gas is then removed. The nitrogen-containing gas, which serves as a plasma supply source, is then supplied, as needed, and the residual gas is then removed. A hydrogen, helium or argon plasma, or a plasma mixture thereof is then supplied, as needed, after which the residual gas is removed. These operations constitute one cycle, where the cycle is repeated until the boron carbonitride-containing film reaches the intended thickness, resulting in the formation of a boron carbonitride-containing film on the substrate.

The hydrogen, helium, or argon plasma, or plasma mixture thereof, may be a direct plasma or a remote plasma, for example. Treatment with such a plasma can reduce or curb the formation of C=N and C≡N bonds that strongly affect the electrical properties and reactivity of boron carbonitride-containing films. Implementing such treatment, as needed, will thus allow the dielectric constant of the boron carbonitride-containing film to be effectively lowered (to a k of no more than 2, for example) and the etching resistance to be enhanced.

An ALD process based on the implementation scheme shown in fig. 2 and 3 can thus be used as a method for forming a boron carbonitride-containing film on a substrate, comprising: (i) supplying a gas comprising at least one boron source compound containing at least one boron halide; and (ii) supplying a gas comprising a carbon-nitrogen source compound represented by formula (1).

However, the method is not limited to an ALD process based on the operating procedure shown in fig. 2 and 3.

For example, the method may include additional post-deposition in situ or ex situ treatments. Examples of additional treatments include: (a) post heat treatment (annealing) at 400-600°C and reduced pressure or in the presence of nitrogen, ammonia, or hydrogen; (b) post plasma treatment at a low temperature (25-400°C) (treatment with nitrogen, ammonia, amine, or hydrazine plasma, hydrogen plasma, or argon or helium plasma); and/or (c) UV treatment at low temperature (25-400°C). These additional treatments can make it easier to form a boron carbonitride-containing film having the desired physical and chemical properties on a substrate.

Flowable CVD (FCVD) can also be used as the method. FCVD can ensure effective gap filling, and is thus suitable for use during shallow trench isolation (STI) and the formation of intermetal dielectric layers or passivation layers, etc.

The method can also be used to obtain compositions that are used in spin-on deposition.

Furthermore, the method can be carried out as a spatial ALD process.

In this embodiment, the reaction between the at least one boron source compound containing at least one boron halide, and the carbon-nitrogen source compound represented by formula (1) can be carried out at 700°C or below or 450°C or below, or from 20°C to 700°C or from 250°C to 450°C, for example. If the boron carbonitride-containing film is deposited on the substrate via a CVD process, the CVD process can be performed at these temperatures.

Specifically, the method of this embodiment can be carried out at these temperatures to allow boron carbonitride-containing films having good physical and chemical properties to be formed on a substrate. Meanwhile, conventional methods generally need to be carried out at higher temperatures in order to form a boron carbonitride-containing film having good physical and chemical properties on a substrate. The method of this embodiment thus enables a substrate on which a boron carbonitride-containing film has been formed to be produced at a relatively low temperature, which can therefore lessen adverse effects on the substrate which are associated with high temperatures, and equipment-related demands.

By-products of the reaction between the at least one boron source compound containing at least one boron halide, and the carbon-nitrogen source compound represented by formula (1) are generally highly volatile, as noted above. These by-products can therefore also be easily removed from the reaction system under the relatively low temperature conditions noted above. In conventional methods, on the other hand, salts (e.g., ammonium halides) are produced in the form of by-products of the reaction, as noted above, but the salts generally have low volatility and are not easy to remove from the reaction system under the relatively low temperature conditions noted above.

In this embodiment, the relative permittivity of the boron carbonitride-containing film may, for example, be 6 or less, 5 or less, or 2 or less, or 2-6, 2-5 or 2-4.

A boron carbonitride-containing film having a relative permittivity in these ranges has a small capacitance and is outstanding as an insulator. Forming a boron carbonitride-containing film having a relative permittivity such as this on a substrate thus makes it possible to effectively insulate a substrate such as an electronic circuit board, for example.

According to the method of this embodiment, the amount of oxygen present in the boron carbonitride-containing film may be reduced to, for example, 10 at% or less, and preferably 1 at% or less, with respect to the boron carbonitride-containing film as a whole.

Oxygen contaminating the boron carbonitride-containing film oxidizes the components of the boron carbonitride-containing film, for example, thereby leading to the possibility of a deterioration in the physical and chemical properties of the boron carbonitride-containing film. Such a possibility is reduced by virtue of the method of this embodiment.

In this embodiment, the substrate may be any substrate, provided that the effects of the present invention are not thereby compromised. The substrate may be in any form, such as in the form of a plate or in the form of powder, granules, or three-dimensional structures. The substrate may be of any material, and may be formed of a material such as silicon, glass, an oxide, ceramic, glass ceramic, or a combination thereof. The substrate may be for any application, and may be, for example, an electronic circuit board or a board other than an electronic circuit board. Electronic circuit boards may be optoelectronic circuit boards.

The substrate in this embodiment can be more strongly protected by a homogeneous boron carbonitride-containing film of high purity. There is also less substrate contamination by by-products in the film-forming step that may adhere to the substrate and adversely affect substrate function. The substrate can thus have better performance, such as in terms of reliability and durability.

### [Method for producing a substrate on which a film has been formed, and a product comprising a substrate on which a film has been formed]

One embodiment provides a method for producing a substrate on which a film has been formed, comprising the method for forming a boron carbonitride-containing film noted above. A method for producing a product comprising a substrate on which a film has been formed, which comprises said method, is also provided. The boron carbonitride-containing film, the method for forming the boron carbonitride-containing film, and the substrate are as described above. The substrate on which a film has been formed has a boron carbonitride-containing film provided on at least one surface of the substrate. The product comprising a substrate on which a film has been formed comprises at least one substrate having a boron carbonitride-containing film provided on at least one surface thereof.

The substrate on which a film has been formed that is produced in this embodiment can be used in any application, provided that the effect of the present invention is not thereby compromised. For example, the substrate can be used as a constituent component of products including electronic devices. Any product comprising a substrate on which a film has been formed that is produced in this embodiment can be selected, provided that the effect of the present invention is not thereby compromised. The product may be an electronic device. Non-limiting examples of electronic devices include computers and peripherals thereof, liquid crystal displays, organic EL displays, smart phones (cell phones), car navigation systems, game devices, televisions, digital cameras/digital video cameras, electronic dictionaries, calculators, printers, and electronic musical instruments.

### [Examples]

The present invention is illustrated by the following examples, but these examples are not intended to limit the present invention. It should be noted that commercially available reagents and equipment, etc., mentioned in the examples were used in accordance with the manufacturer's instructions or standard methods, unless otherwise specified.

### [Example 1]

### Formation of a boron carbonitride-containing film employing BBr₃ and (H₃C)₃SiN=C=N-Si(CH₃)₃ by means of ALD (450°C)

N₂ gas comprising BBr₃ was used as the gas comprising a boron source compound, and N₂ gas comprising (H₃C)₃Si-N=C=N-Si(CH₃)₃ (BTMSCDI) was used as the gas comprising a carbon-nitrogen source compound.

A boron carbonitride-containing film was formed on a silicon substrate by means of ALD at 450°C using a tubular horizontal flow type of hot-wall quartz reactor. The conditions in the ALD are shown in tables 1A and 1B.

**[Table 1A]**

| Pressure (Torr) | Temperature (°C) | Flow rate (sccm) | | | |
|---|---|---|---|---|---|
| | | BBr₃/N₂ | BTMSCDI/N₂ | Process N₂ gas | Purge N₂ gas |
| 8 | 450 | 6.3/20 | 6.7/35 | 40 | 120 |

**[Table 1B]**

| Number of cycles | BBr₃ pulse (seconds) | N₂ purging (seconds) | BTMSCDI pulse (seconds) | N₂ purging (seconds) |
|---|---|---|---|---|
| 300 | 15 | 20 | 15 | 10 |

The thickness, film formation rate (GPC), refractive index (633 nm), dielectric constant (k), wet etching resistance (WER), and step coverage of the boron carbonitride-containing film were analysed. The results are shown in Table 2.

The thickness of the boron carbonitride-containing film was determined by ellipsometry.

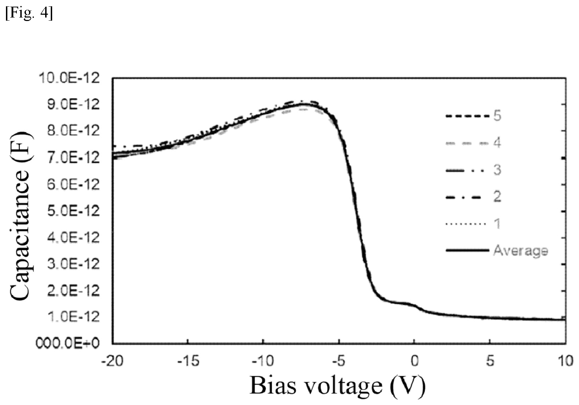

The dielectric constant (k) of the boron carbonitride-containing film was measured by a standard method on the basis of the C-V curve shown in fig. 4.

**[Table 2]**

| Thin layer thickness (nm) | GPC (Å/cycle) | Refractive index (633 nm) | k | WER (10-minute soaking in 1% HF) | Step coverage (Bottom surface/side top) |
|---|---|---|---|---|---|
| | | | | | AR20 |
| 34.4 | 1.1 | 2.057 | 4.8 | No etching | 99% |

High wet etching resistance was demonstrated, as shown in table 2. It should be noted that WER of an SiO₂ thermal oxide film measured under the same conditions was 5.6 nm/minute.

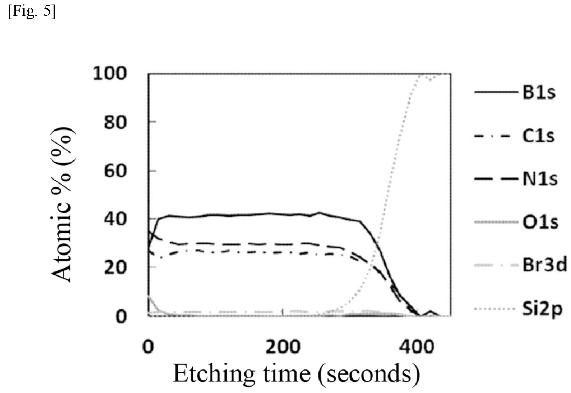

Furthermore, the constituent elements of the boron carbonitride-containing film of example 1 were analysed by means of X-ray photoelectron spectroscopy (XPS) (fig. 5). The composition of the boron carbonitride-containing film of example 1 (etching time: 100 seconds) comprised 41.6% of B1s, 29.8% of N1s, 26.4% of C1s, and 0.1% of O1s. Specifically, the boron carbonitride-containing film of example 1 had a rich B content but a low O content.

O contaminating the boron carbonitride-containing film oxidizes the components of the boron carbonitride-containing film, thereby leading to the possibility of a deterioration in the physical and chemical properties of the boron carbonitride-containing film. There is little possibility of such an occurrence in the boron carbonitride-containing film of this example which has a low oxygen content.

### [Example 2]

### Formation of a boron carbonitride-containing film employing BBr₃ and (H₃C)₃SiN=C=N-Si(CH₃)₃ by means of ALD (250°C)

N₂ gas comprising BBr₃ was used as the gas comprising a boron source compound, and N₂ gas comprising (H₃C)₃Si-N=C=N-Si(CH₃)₃ (BTMSCDI) was used as the gas comprising a carbon-nitrogen source compound, in the same way as in example 1.

A boron carbonitride-containing film was formed on a silicon substrate by means of ALD at 250°C using a tubular horizontal flow type of hot-wall quartz reactor. The conditions in the ALD are shown in tables 3A and 3B.

**[Table 3A]**

| Pressure (Torr) | Temperature (°C) | Flow rate (sccm) | | | |
|---|---|---|---|---|---|
| | | BBr₃/N₂ | BTMSCDI/N₂ | Process N₂ gas | Purge N₂ gas |
| 8 | 250 | 6.3/20 | 6.7/35 | 40 | 120 |

**[Table 3B]**

| Number of cycles | BBr₃ pulse (seconds) | N₂ purging (seconds) | BTMSCDI pulse | N₂ purging (seconds) | NH₃ pulse (seconds) | N₂ purging (seconds) |
|---|---|---|---|---|---|---|
| | | | (seconds) | | | |
| 300 | 15 | 20 | 15 | 10 | 10 | 10 |

The results of measuring the thickness of a thin layer, film formation rate (GPC), refractive index (633 nm), and wet etching resistance (WER) are shown in table 4.

**[Table 4]**

| Thin layer thickness (nm) | GPC (Å/cycle) | Refractive index (633 nm) | WER (10-minute soaking in 1% HF) |
|---|---|---|---|
| 62 | 2.1 | 1.874 | No etching |

As shown in table 4, the boron carbonitride-containing film of example 2 had a good thickness, and the film was formed with a good film formation rate.

Furthermore, the boron carbonitride-containing film of example 2 exhibited high wet etching resistance.

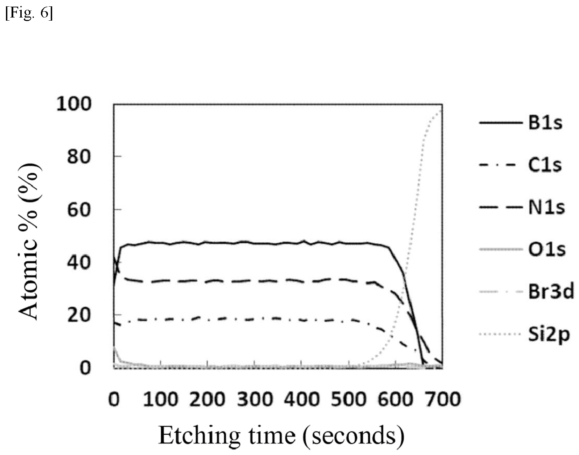

Furthermore, the constituent elements of the boron carbonitride-containing film of example 2 were analysed by means of X-ray photoelectron spectroscopy (XPS) (fig. 6). The composition of the boron carbonitride-containing film of example 2 (etching time: 100 seconds) comprised 46.1% of B1s, 35.4% of N1s, 17.4% of C1s, and 0.6% of O1s. Specifically, the boron carbonitride-containing film of example 2 had a rich B content but a low O content, in the same way as the boron carbonitride-containing film of example 1.

A non-limiting list of exemplary embodiments and combinations of exemplary embodiments of the present disclosure is disclosed below.
[1] A method for forming a boron carbonitride-containing film on a substrate, the method comprising:
   (i) supplying at least one boron source compound containing at least one boron halide onto the substrate; and
   (ii) supplying, onto the substrate, a carbon-nitrogen source compound represented by formula (1):

      R¹₃E-N=C=N-ER¹₃

      [in formula (1), E are independently Si, Ge or Sn, and R¹ are independently a C1-C6 alkyl, C2-C6 alkenyl, C4-C6 cycloalkyl, or C4-C6 cycloalkenyl].
[2] The method according to [1], wherein E in formula (1) is Si.
[3] The method according to [1] or [2], wherein R¹ in formula (1) is CH₃.
[4] The method according to any of [1] to [3], wherein the at least one boron source compound is selected from the group consisting of: BCl₃, BBr₃, BI₃, CH₃BCl₂, CH₃BBr₂, C₆H₅BCl₂, borazine, 2,4,6-trichloroborazine, 1,3,5-trimethyl-2,4,6-trichloroborazine, and 1,3,5-triethyl-2,4,6-trichloroborazine.
[5] The method according to any of [1] to [3],
   wherein the at least one boron source compound is a compound represented by formula (2):

   X₃Si-[CR²R³]ₙ-BX₂

   [in formula (2), X is Cl, Br, or I; R² and R³ are independently H or a C1-C6 alkyl, C2-C6 alkenyl, C4-C6 cycloalkyl, or C4-C6 cycloalkenyl; R² and R³ may be bonded to each other by C-C bonds to form a carbon ring structure; and n is an integer of 1-10].
[6] The method according to [5], where in the compound represented by formula (2) is a compound selected from the group consisting of: Cl₃Si-CH₂-BCl₂, Cl₃Si-CH(CH₃)-BCl₂, Cl₃Si-C(CH₃)₂-BCl₂, Cl₃Si-C(CH₂)-BCl₂, Cl₃Si-C[C(CH₃)₂]-BCl₂, Br₃Si-CH₂-BCl₂, Br₃Si-CH₂-BBr₂, Br₃Si-CH(CH₃)-BCl₂, Br₃Si-CH(CH₃)-BBr₂, Br₃Si-C(CH₃)₂-BCl₂, Br₃Si-C(CH₃)₂-BBr₂, Br₃Si-C(CH₂)-BCl₂, Br₃Si-C(CH₂)-BBr₂, Br₃Si-C[C(CH₃)₂]-BCl₂, Br₃Si-C[C(CH₃)₂]-BBr₂, Cl₃Si-CH₂-BBr₂, Cl₃Si-CH(CH₃)-BBr₂, Cl₃Si-C(CH₃)₂-BBr₂, Cl₃Si-C(CH₂)-BBr₂, and Cl₃Si-C[C(CH₃)₂]-BBr₂.
[7] The method according to any of [1] to [3],
   wherein the at least one boron source compound is a compound represented by formula (3):

   X₂B-Aₙ-BX₂

   [in formula (3):
   (i) A is CR²R³, n is an integer of 1-6, or (ii) A is C=CR²R³, and n is 1;
   R² and R³ are independently H, or a C1-C6 alkyl, C2-C6 alkenyl, C4-C6 cycloalkyl, or C4-C6 cycloalkenyl;
   R² and R³ may be bonded to each other by C-C bonds to form a carbon ring structure; and
   X is F, Cl, Br or I].
[8] The method according to [7], wherein the compound represented by formula (3) is a compound selected from the group consisting of: Cl₂B-CH₂-BCl₂, Cl₂B-CH(CH₃)-BCl₂, Cl₂B-C(CH₃)₂-BCl₂, Cl₂B-C(CH₂)-BCl₂, Cl₂B-C[C(CH₃)₂]-BCl₂, Br₂B-CH₂-BBr₂, Br₂B-CH(CH₃)-BBr₂, Br₂B-C(CH₃)₂-BBr₂, Br₂B-C(CH₂)-BBr₂, Br₂B-C[C(CH₃)₂]-BBr₂, Cl₂B-CH₂-BBr₂, Cl₂B-CH(CH₃)-BBr₂, Cl₂B-C(CH₃)₂-BBr₂, Cl₂B-C(CH₂)-BBr₂, and Cl₂B-C[C(CH₃)₂]-BBr₂.
[9] The method according to any of [1] to [8], further comprising: (iii) supplying a nitrogen-containing reagent onto the substrate.
[10] The method according to [9], wherein the nitrogen-containing reagent is:
   (i) one or more selected from the group consisting of ammonia, amines, hydrazines, alkylhydrazines, hexamethyldisilazane, and heptamethyldisilazane;
   (ii) one or more plasmas selected from the group consisting of ammonia, amines, hydrazines, alkylhydrazines, hexamethyldisilazane, and heptamethyldisilazane;
   (iii) nitrogen plasma; or
   (iv) a mixture of hydrogen plasma with (ii) one or more plasmas selected from the group consisting of ammonia, amines, hydrazines, alkylhydrazines, hexamethyldisilazanes, and heptamethyldisilazanes, or (iii) nitrogen plasma.
[11] The method according to any of [1] to [10], wherein the at least one boron source compound and the carbon-nitrogen source compound are sequentially supplied onto the substrate.
[12] The method according to any of [1] to [10], wherein the at least one boron source compound and the carbon-nitrogen source compound are supplied simultaneously onto the substrate.
[13] The method according to any of [1] to [12], wherein the boron carbonitride-containing film is formed on the substrate by means of a chemical vapour deposition process.
[14] The method according to any of [1] to [13], wherein the boron carbonitride-containing film is formed on the substrate by means of an atomic layer deposition process.
[15] The method according to any of [1] to [14], wherein the boron carbonitride-containing film is a boron carbonitride film.
[16] The method according to any of [1] to [14], wherein the boron carbonitride-containing film is a silicoboron carbonitride film.
[17] The method according to any of [1] to [16], wherein the substrate is an electronic circuit board.
[18] A method for producing substrate on which a film has been formed, comprising a method according to any of [1] to [17].
[19] A method for producing a product comprising a substrate on which a film has been formed, comprising the method according to [18].
[20] The method according to [19], wherein the product comprising a substrate on which a film has been formed is an electronic device.

## Claims

1. Method for forming a boron carbonitride-containing film on a substrate, the method comprising:
(i) supplying at least one boron source compound containing at least one boron halide onto the substrate; and
(ii) supplying, onto the substrate, a carbon-nitrogen source compound represented by formula (1):
R¹₃E-N=C=N-ER¹₃
[in formula (1), E are independently Si, Ge or Sn, and R¹ are independently a C1-C6 alkyl, C2-C6 alkenyl, C4-C6 cycloalkyl, or C4-C6 cycloalkenyl].

2. Method according to Claim 1, wherein E in formula (1) is Si.

3. Method according to Claim 1, wherein R¹ in formula (1) is CH₃.

4. Method according to Claim 1, wherein the at least one boron source compound is selected from the group consisting of: BCl₃, BBr₃, BI₃, CH₃BCl₂, CH₃BBr₂, C₆H₅BCl₂, borazine, 2,4,6-trichloroborazine, 1,3,5-trimethyl-2,4,6-trichloroborazine, and 1,3,5-triethyl-2,4,6-trichloroborazine.

5. Method according to claim 1,
wherein the at least one boron source compound is a compound represented by formula (2):
X₃Si-[CR²R³]ₙ-BX₂
[in formula (2), X is Cl, Br, or I; R² and R³ are independently H or a C1-C6 alkyl, C2-C6 alkenyl, C4-C6 cycloalkyl, or C4-C6 cycloalkenyl; R² and R³ may be bonded to each other by C-C bonds to form a carbon ring structure; and n is an integer of 1-10].

6. Method according to Claim 5, wherein the compound represented by formula (2) is a compound selected from the group consisting of: Cl₃Si-CH₂-BCl₂, Cl₃Si-CH(CH₃)-BCl₂, Cl₃Si-C(CH₃)₂-BCl₂, Cl₃Si-C(CH₂)-BCl₂, Cl₃Si-C[C(CH₃)₂]-BCl₂,Br₃Si-CH₂-BCl₂, Br₃Si-CH₂-BBr₂, Br₃Si-CH(CH₃)-BCl₂, Br₃Si-CH(CH₃)-BBr₂, Br₃Si-C(CH₃)₂-BCl₂,Br₃Si-C(CH₃)₂-BBr₂, Br₃SiC(CH₂)-BCl₂, Br₃Si-C(CH₂)-BBr₂, Br₃Si-C[C(CH₃)₂]-BCl₂, Br₃Si-C[C(CH₃)₂]-BBr₂, Cl₃Si-CH₂-BBr₂, Cl₃Si-CH(CH₃)-BBr₂, Cl₃Si-C(CH₃)₂-BBr₂, Cl₃Si-C(CH₂)-BBr₂, and Cl₃Si-C[C(CH₃)₂]-BBr₂.

7. Method according to Claim 1, wherein the at least one boron source compound is a compound represented by formula (3):
X₂B-Aₙ-BX₂
[in formula 3:
(i) A is CR²R³, n is an integer of 1-6, or (ii) A is C=CR²R³, and n is 1;
R² and R³ are independently H, or a C1-C6 alkyl, C2-C6 alkenyl, C4-C6 cycloalkyl, or C4-C6 cycloalkenyl;
R² and R³ may be bonded to each other by C-C bonds to form a carbon ring structure; and
X is F, Cl, Br or I].

8. Method according to Claim 7, wherein the compound represented by formula (3) is a compound selected from the group consisting of: Cl₂B-CH₂-BCl₂, Cl₂B-CH(CH₃)-BCl₂, Cl₂B-C(CH₃)₂-BCl₂, Cl₂B-C(CH₂)-BCl₂, Cl₂B-C[C(CH₃)₂]-BCl₂,Br₂B-CH₂-BBr₂, Br₂B-CH(CH₃)-BBr₂, Br₂B-C(CH₃)₂-BBr₂, Br₂B-C(CH₂)-BBr₂, Br₂B-C[C(CH₃)₂]-BBr₂, Cl₂B-CH₂-BBr₂, Cl₂B-CH(CH₃)-BBr₂, Cl₂B-C(CH₃)₂-BBr₂, Cl₂B-C(CH₂)-BBr₂, and Cl₂B-C[C(CH₃)₂]-BBr₂.

9. Method according to claim 1, further comprising:
(iii) supplying a nitrogen-containing reagent onto the substrate.

10. Method according to Claim 9, wherein the nitrogen-containing reagent is:
(i) one or more selected from the group consisting of ammonia, amines, hydrazines, alkylhydrazines, hexamethyldisilazane, and heptamethyldisilazane;
(ii) one or more plasmas selected from the group consisting of ammonia, amines, hydrazines, alkylhydrazines, hexamethyldisilazane, and heptamethyldisilazane;
(iii) nitrogen plasma; or
(iv) a mixture of hydrogen plasma with (ii) one or more plasmas selected from the group consisting of ammonia, amines, hydrazines, alkylhydrazines, hexamethyldisilazane, and heptamethyldisilazane, or (iii) nitrogen plasma.

11. Method according to Claim 1, wherein the at least one boron source compound and the carbon-nitrogen source compound are supplied sequentially onto the substrate.

12. Method according to Claim 1, wherein the at least one boron source compound and the carbon-nitrogen source compound are supplied simultaneously onto the substrate.

13. Method according to Claim 1, wherein the boron carbonitride-containing film is formed on the substrate by means of a chemical vapour deposition process.

14. Method according to Claim 1, wherein the boron carbonitride-containing film is formed on the substrate by means of an atomic layer deposition process.

15. Method according to Claim 1, wherein the boron carbonitride-containing film is a boron carbonitride film.

16. Method according to Claim 1, wherein the boron carbonitride-containing film is a silicoboron carbonitride film.

17. Method according to Claim 1, wherein the substrate is an electronic circuit board.

18. Method for producing a substrate on which a film has been formed, comprising a method according to any one of Claims 1 to 17.

19. Method for producing a product comprising a substrate on which a film has been formed, comprising the method according to Claim 18.

20. Method according to Claim 19, wherein the product comprising a substrate on which a film has been formed is an electronic device.
